# EUROPEAN PATENT APPLICATION

(11) **EP 4 333 024 A1**
(43) Date of publication of application: **06.03.2024**
(21) Application number: 22795679.4
(22) Date of filing: 22.04.2022
(51) Int. Cl.: H01L 21/02, F17D 5/00, G01M 3/26

(54) **GAS PROCESSING SYSTEM**

(30) Priority: 28.04.2021 JP 2021076002; 15.03.2022 JP 2022040144
(71) Applicant: Edwards Japan Limited, Yachiyo-shi, Chiba 276-8523 (JP)
(72) Inventor: GUAN, Jinquan, Yachiyo-shi Chiba 276-8523 (JP); TANAKA, Masahiro, Yachiyo-shi Chiba 276-8523 (JP); ABE, Mitsunori, Yachiyo-shi Chiba 276-8523 (JP)
(74) Representative: Openshaw & Co.
(86) International application number: PCT/JP2022/018537
(87) International publication number: WO 2022/230766

(57) **Abstract**

Provided is a gas treatment system that can accurately detect internal leakage in a three-way valve and can suppress leakage of exhaust gas to a bypass line. A gas treatment system 10 includes: a main exhaust line 22 for guiding exhaust gas to a detoxification apparatus 40; a bypass line 30 for guiding the exhaust gas to an emergency detoxification apparatus 50; an upstream exhaust line 21; and a three-way valve 23 capable of switching a flow of the exhaust gas from the upstream exhaust line 21 to the main exhaust line 22 or the bypass line 30, in which the bypass line 30 includes: a gate valve 33; a gas introduction pipe 34 through which a second gas is introduced; and a pressure gauge 35 configured to detect pressure. If the three-way valve 23 discharges gas to the main exhaust line 22, in a state where the second gas has been introduced into a closed flow path C between the gate valve 33 and the three-way valve 23 from the gas introduction pipe 34, internal leakage in the three-way valve 23 is detectable using change in the pressure detected by the pressure gauge 35.

## Description

### TECHNICAL FIELD

The present invention relates to a gas treatment system.

### BACKGROUND ART

A semiconductor manufacturing apparatus requires that the environment inside the apparatus is in a highly vacuum state. Vacuum pumps are used to create a highly vacuum state inside these apparatuses. The exhaust gas discharged from the vacuum pump contains a detoxification gas that needs to be detoxified. Therefore, the exhaust gas is sent to a detoxification apparatus through an exhaust line and is subjected to detoxification treatment.

In some cases, a three-way valve is arranged in the exhaust line, and a main exhaust line and a bypass line branch from the three-way valve (e.g., see PTL 1). A detoxification apparatus is arranged downstream of the main exhaust line, and an emergency detoxification apparatus that temporarily performs detoxification treatment when an abnormality occurs in the detoxification apparatus is connected downstream of the bypass line. Normally, the exhaust gas flowing through the exhaust line is not sent to the bypass line through the three-way valve, but is sent to the detoxification apparatus through the main exhaust line and is subjected to the detoxification treatment. Then, when an abnormality occurs in the detoxification device, the three-way valve is switched, and the exhaust gas is sent to the emergency detoxification apparatus through the bypass line instead of the main exhaust line, and is simply subjected to the detoxification treatment.

### CITATION LIST

### PATENT LITERATURE

[PTL 1] JP 2020-25096A

### SUMMARY OF INVENTION

### TECHNICAL PROBLEM

Incidentally, the exhaust line and the three-way valve are set to a high temperature so that the detoxification gas does not solidify and accumulate inside. That is, by raising the temperature of the target detoxification gas to a high temperature, the state of the detoxification gas is positioned on the gas phase side of the vapor pressure curve, and solidification of the detoxification gas is suppressed.

When the three-way valve reaches a high temperature, there is a possibility that the sealing performance of the three-way valve will deteriorate and internal leakage will occur. In this case, a phenomenon occurs in which the detoxification gas flows to the bypass line even though the three-way valve is open on the main exhaust line side in order to detoxify the detoxification gas. Since the emergency detoxification apparatus connected to the bypass line basically does not have high detoxification performance, if a large amount of detoxification gas flows in, there is a possibility that the emergency detoxification apparatus will not be able to completely process it.

In order to suppress internal leakage of the three-way valve, it is possible to take measures to raise the heat resistance temperature of the seal of the three-way valve, but even if the heat resistance temperature is raised, the sealing performance will inevitably deteriorate due to a high temperature of the three-way valve. For this reason, it is desired that internal leakage of the three-way valve can be accurately detected.

The present invention has been made to solve the above-mentioned problems, and aims to provide a gas treatment system that can accurately detect internal leakage in a three-way valve that branches a flow path of exhaust gas, and can suppress leakage of the exhaust gas from the three-way valve to the bypass line.

### SOLUTION TO PROBLEM

The gas treatment system according to the present invention that achieves the above-described object is a gas treatment system including: a main exhaust line for guiding exhaust gas to a gas treatment apparatus; a bypass line for guiding the exhaust gas to equipment other than the gas treatment apparatus; an upstream exhaust line for guiding the exhaust gas to the main exhaust line and the bypass line; and a three-way valve capable of switching a flow of the exhaust gas from the upstream exhaust line to the main exhaust line or the bypass line, in which the bypass line includes: a gate valve; a gas introduction pipe through which a second gas is introduced between the three-way valve and the gate valve; and a pressure gauge configured to detect pressure between the three-way valve and the gate valve, and if the three-way valve discharges gas to the main exhaust line, the gate valve is closed to form a closed flow path between the gate valve and the three-way valve, and in a state where the second gas has been introduced into the closed flow path from the gas introduction pipe, internal leakage in the three-way valve is detectable using change in pressure detected by the pressure gauge.

### ADVANTAGEOUS EFFECTS OF INVENTION

The gas treatment system configured as described above can accurately detect internal leakage in the three-way valve due to change in the pressure in the closed flow path detected by the pressure gauge, and can suppress leakage of the exhaust gas to the bypass line using the second gas introduced into the closed flow path.

The gas introduction pipe may include a second gate valve, and after the second gas is introduced from the gas introduction pipe, the pressure in the closed flow path may be maintainable by closing the second gate valve, and internal leakage in the three-way valve may be detectable using the change in the pressure in the closed flow path detected by the pressure gauge. Since the gas treatment system can maintain the pressure in the closed flow path by closing the second gate valve, it is easier to detect change in the pressure in the closed flow path caused by internal leakage and the gas treatment system can accurately detect internal leakage in the three-way valve.

The second gas may be continuously introduced from the gas introduction pipe in a state where internal leakage in the three-way valve is detectable. As a result, since the pressure in the closed flow path can be prevented from decreasing with time, the gas treatment system can suitably maintain a state in which the change in the pressure in the closed flow path can be detected even if time has elapsed.

The second gas may be introduced from the gas introduction pipe only for a predetermined time in a state where internal leakage in the three-way valve is detectable. As a result, since the gas treatment system does not need to continuously maintain the pressure in the closed flow path, but only needs to keep it constant for a limited time, it is easier to detect change in the pressure in the closed flow path caused by internal leakage and internal leakage in the three-way valve can be detected with a high accuracy.

The gas introduction pipe may have a diaphragm mechanism for adjusting a flow rate of the second gas. As a result, in the gas treatment system, the flow rate of the second gas is limited to a small amount by the diaphragm mechanism. For this reason, the change over time in the pressure in the closed flow path caused by the inflow of the second gas becomes gradual. For this reason, change in the pressure in the closed flow path caused by leakage in the three-way valve is less likely to be buried in the change in the pressure in the closed flow path caused by the inflow of the second gas, and thus the leakage is easier to identify. For this reason, the gas treatment system can detect internal leakage in the three-way valve with high accuracy.

The gate valve may be a normally-open valve. As a result, if a defect occurs in the structure operating the gate valve, the gate valve automatically opens, and the gas flowing through the bypass line is urgently discharged to equipment other than the gas treatment apparatus. For this reason, the gas treatment system can ensure high safety.

### BRIEF DESCRIPTION OF DRAWINGS

[FIG. 1] FIG. 1 is a configuration diagram of a gas treatment system according to the present embodiment;
[FIG. 2] FIG. 2 is a configuration diagram of when internal leakage occurs in a three-way valve of the gas treatment system according to the present embodiment;
[FIG. 3] FIG. 3 is a configuration diagram of when a defect occurs in a detoxification apparatus of the gas treatment system according to the present embodiment; and
[FIG. 4] FIG. 4 is a configuration diagram of a modified example of the gas treatment system according to the present embodiment.

### DESCRIPTION OF EMBODIMENTS

Hereinafter, embodiments of the present invention will be described with reference to the drawings. Note that in some cases, the dimensions in the drawings are exaggerated and differ from the actual dimensions for convenience of description. Also, in the present specification and the drawings, components having substantially the same functional configuration are denoted by the same reference numerals, and redundant description is omitted.

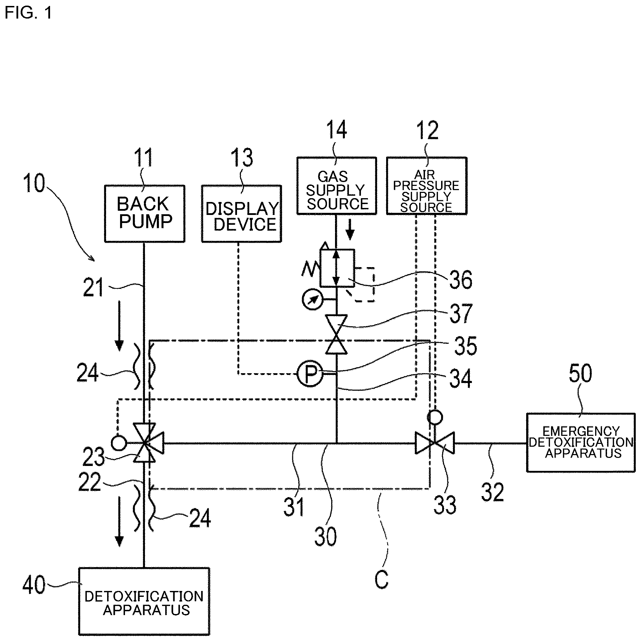

As shown in FIG. 1, a gas treatment system 10 according to an embodiment of the present invention includes an upstream exhaust line 21 to which exhaust gas discharged from a vacuum pump (not shown) connected to a semiconductor manufacturing apparatus or the like is fed, a main exhaust line 22 arranged downstream of the upstream exhaust line 21, a three-way valve 23 arranged between the upstream exhaust line 21 and the main exhaust line 22, and a detoxification apparatus 40 arranged downstream of the main exhaust line 22. The gas treatment system 10 further includes a bypass line 30 connected to the three-way valve 23 and an emergency detoxification apparatus 50 arranged downstream of the bypass line 30. The upstream exhaust line 21, the main exhaust line 22, and the bypass line 30 have a piping structure that forms a flow path through which exhaust gas flows.

The upstream exhaust line 21 is connected to, for example, a back pump 11 to which the exhaust gas is fed from the vacuum pump, and the exhaust gas is fed to the upstream exhaust line 21 from the back pump 11. Note that the configuration arranged upstream of the upstream exhaust line 21 is not limited to the back pump 11. The exhaust gas flowing through the upstream exhaust line 21 contains a detoxification gas that needs to be detoxified. The detoxification gas is a highly volatile substance that sublimates when heated, and is, but is not limited to, for example, ammonium chloride. The downstream end of the upstream exhaust line 21 is connected to the three-way valve 23.

The upstream end of the main exhaust line 22 is connected to the three-way valve 23, and the downstream end of the main exhaust line 22 is connected to the detoxification apparatus 40. At least one of the upstream exhaust line 21 and the main exhaust line 22 is provided with a piping heater 24. The piping heater 24 heats the piping of at least one of the upstream exhaust line 21 and the main exhaust line 22 to prevent the detoxification gas flowing inside the pipe from accumulating in the pipe. The set temperature of the piping heater 24 is appropriately set depending on conditions such as the type of detoxification gas and pressure, and in some cases is, but is not limited to, for example, 200°C or higher.

The three-way valve 23 is connected to the upstream exhaust line 21, the main exhaust line 22, and the bypass line 30. The three-way valve 23 can switch between a state in which the flow paths of the upstream exhaust line 21 and the main exhaust line 22 are in communication with each other and a state in which the flow paths of the upstream exhaust line 21 and the bypass line 30 are in communication with each other. The switching operation of the three-way valve 23 is performed by, for example, an actuator operated by the air pressure supplied from an air pressure supply source 12. Note that the method of switching the three-way valve 23 is not limited to this, and may be performed by, for example, a hydraulic actuator, an electric actuator, or the like.

The detoxification apparatus 40 is a gas treatment apparatus that performs detoxification treatment on the detoxification gas in order to prevent air pollution. Although there is no particular limitation on the structure of the detoxification apparatus 40, the detoxification gas can be subjected to detoxification treatment through a method that is of a combustion type, a thermal decomposition type, a wet type, a catalytic type, a plasma decomposition type, an adsorption type, or the like. Note that the gas treatment apparatus to which the exhaust gas is transported need not be the detoxification apparatus 40.

The bypass line 30 includes a first bypass line 31, a second bypass line 32, a gate valve 33, a gas introduction pipe 34 that introduces a second gas into the first bypass line 31 between the three-way valve 23 and the gate valve 33, and a pressure gauge 35 that detects the pressure between the three-way valve 23 and the gate valve 33. The upstream end of the first bypass line 31 is connected to the three-way valve 23, and the downstream end of the first bypass line 31 is connected to the gate valve 33. The upstream end of the second bypass line 32 is connected to the gate valve 33 and the downstream end of the second bypass line 32 is connected to the emergency detoxification apparatus 50. The emergency detoxification apparatus 50 is a gas treatment apparatus that performs detoxification treatment on the detoxification gas in place of the detoxification apparatus 40 when an abnormality occurs in the detoxification apparatus 40. Note that the emergency detoxification apparatus 50 is a gas treatment apparatus with a simple structure that mainly performs treatment through dilution, and basically has low detoxification performance.

The gate valve 33 is a valve capable of opening and closing the flow path between the first bypass line 31 and the second bypass line 32. Similar to the three-way valve 23, the operation of switching the opening and closing of the gate valve 33 is performed by, for example, an actuator operated by the air pressure supplied from the air pressure supply source 12. Note that the method of switching the gate valve 33 is not limited to this, and may be performed by, for example, a hydraulic actuator, an electric actuator, or the like. The gate valve 33 is opened and closed in synchronization with the three-way valve 23. That is, when the space between the upstream exhaust line 21 and the first bypass line 31 of the three-way valve 23 opens, the gate valve 33 opens, and when the space between the upstream exhaust line 21 and the first bypass line 31 of the three-way valve 23 closes, the gate valve 33 closes. It is preferable that the gate valve 33 is a normally-open valve that automatically opens when a force for closing the valve is not applied. The gate valve 33 is, for example, a spring-return valve that is automatically opened by the action of an internal spring. As a result, if a defect occurs in the structure that operates the gate valve 33, the gate valve 33 automatically opens, and the gas flowing through the bypass line 30 is discharged to the emergency detoxification apparatus 50 to ensure safety.

The gas introduction pipe 34 is piping for supplying a second gas to the bypass line 30. The gas introduction pipe 34 includes a pressure regulator 36 that regulates the pressure of the second gas supplied from the gas supply source 14, and a second gate valve 37 arranged between the pressure regulator 36 and the first bypass line 31. The second gas supplied from the gas supply source 14 is used to increase the pressure in a closed flow path C of the bypass line 30 closed by the three-way valve 23, the gate valve 33, and the second gate valve 37. The second gas supplied from the gas supply source 14 is preferably nitrogen gas, but there is no particular limitation thereto as long as it is an inert gas, and the second gas may be, for example, argon gas or the like.

The second gate valve 37 is a valve that can open and close the flow path between the pressure regulator 36 and the first bypass line 31. The operation of switching between the opening and closing of the second gate valve 37 is performed manually, but may also be performed by, for example, an actuator of a pneumatic type, a hydraulic type, an electric type, or the like.

The pressure gauge 35 is connected to piping that is between the three-way valve 23 and the gate valve 33 of the bypass line 30 and is closer to the first bypass line 31 than the second gate valve 37, and detects the pressure inside the bypass line 30. That is, the pressure gauge 35 detects the pressure in the closed flow path C of the bypass line 30 closed by the three-way valve 23, the gate valve 33, and the second gate valve 37. The pressure detection result by the pressure gauge 35 is used to detect internal leakage to the bypass line 30 in the three-way valve 23. In the present embodiment, the pressure gauge 35 is connected to the gas introduction pipe 34 that is in communication with the first bypass line 31, but may also be connected to the first bypass line 31. The pressure gauge 35 transmits a signal indicating the detected result to a display device 13. The display device 13 displays the pressure detection result received from the pressure gauge 35 so that the operator can visually recognize it.

Next, the operation of the gas treatment system 10 according to the present embodiment will be described.

First, the three-way valve 23 brings the flow paths of the upstream exhaust line 21 and the main exhaust line 22 into communication with each other and closes the flow paths of the upstream exhaust line 21 and the bypass line 30. In synchronization with this, the gate valve 33 is closed. Next, the second gate valve 37 is opened and the second gas is supplied from the gas supply source 14 to the closed flow path C of the bypass line 30 through the pressure regulator 36. The pressure P in the closed flow path C of the bypass line 30 is set to a predetermined pressure P0 (P=P0). Thereafter, the worker closes the second gate valve 37. As a result, the pressure in the closed flow path C of the bypass line 30 is maintained at the predetermined pressure P0. In one example, the pressure of the second gas supplied from the gas supply source 14 is about 10 kPa to 100 kPa, and the predetermined pressure P0 in the closed flow path C is set to about 1 kPa to 100 kPa.

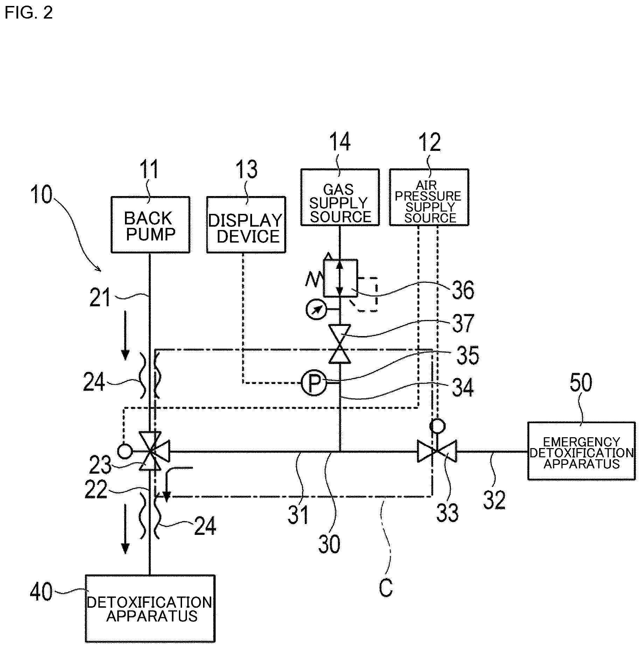

Next, the worker heats at least one of the upstream exhaust line 21 and the main exhaust line 22 with the piping heater 24. Thereafter, the exhaust gas from the back pump 11 is allowed to flow to the detoxification apparatus 40 via the upstream exhaust line 21 and the main exhaust line 22. The exhaust gas that has reached the detoxification apparatus 40 is released to the outside after the detoxification gas is subjected to detoxification treatment. In one example, the pressure of the exhaust gas flowing through the upstream exhaust line 21 and the main exhaust line 22 is several kPa. The pressure P in the closed flow path C is greater than the pressure of the exhaust gas flowing through the upstream exhaust line 21 and the main exhaust line 22. Accordingly, when internal leakage occurs in the seal of the three-way valve 23, as shown in FIG. 2, the second gas inside the closed flow path C leaks to the main exhaust line 22 through the three-way valve 23. Since the second gas that leaks is nitrogen gas, the effect on the gas treatment system 10 is small. When the second gas inside the closed flow path C leaks internally from the three-way valve 23 to the main exhaust line 22, the pressure P in the closed flow path C drops below the initially-set predetermined pressure P0 (P<P0). The worker monitors the pressure P in the closed flow path C with the display device 13 and determines whether or not there is a leak in the three-way valve 23. The worker determines that internal leakage is occurring in the three-way valve 23 if, for example, the pressure P in the closed flow path C becomes a pre-set threshold value or less (or less than the threshold value), the threshold value being lower than the predetermined pressure P0.

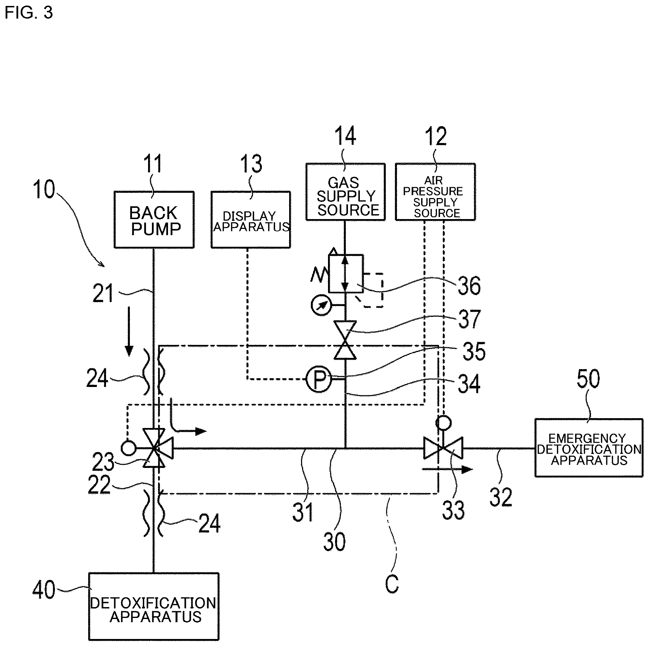

When an abnormality occurs in the detoxification apparatus 40, as shown in FIG. 3, the worker switches the three-way valve 23 to close the flow paths of the upstream exhaust line 21 and the main exhaust line 22, and opens the flow paths of the upstream exhaust line 21 and the bypass line 30 to bring them into communication with each other. In synchronization with this, the gate valve 33 opens. As a result, the exhaust gas flowing through the upstream exhaust line 21 does not flow to the main exhaust line 22, but flows to the bypass line 30 and is fed to the emergency detoxification apparatus 50 to be subjected to detoxification treatment.

As described above, the gas treatment system 10 according to the present embodiment is the gas treatment system 10 that includes the main exhaust line 22 that guides the exhaust gas to the gas treatment apparatus (detoxification apparatus 40), the bypass line 30 that guides the exhaust gas to equipment (emergency detoxification apparatus 50) other than the detoxification apparatus 40, the upstream exhaust line 21 that guides the exhaust gas to the main exhaust line 22 and the bypass line 30, the three-way valve 23 that can switch the flow of the exhaust gas from the upstream exhaust line 21 to the main exhaust line 22 or the bypass line 30, in which the bypass line 30 includes the gate valve 33, the gas introduction pipe 34 that introduces the second gas between the three-way valve 23 and the gate valve 33, and the pressure gauge 35 that detects the pressure between the three-way valve 23 and the gate valve 33, and if the three-way valve 23 discharges gas to the main exhaust line 22, the closed flow path C is formed between the gate valve 33 and the three-way valve 23 by closing the gate valve 33, and when the second gas is further introduced into the closed flow path C from the gas introduction pipe 34, internal leakage in the three-way valve 23 can be detected based on a change in pressure detected by the pressure gauge 35.

The gas treatment system 10 configured as described above can accurately detect the internal leakage in the three-way valve 23 based on the change in the pressure in the closed flow path C detected by the pressure gauge 35, and can suppress leakage of the exhaust gas to the bypass line 30 using the second gas introduced to the closed flow path C. If the pressure P in the closed flow path C is higher than the pressure of the exhaust gas flowing through the upstream exhaust line 21 and the main exhaust line 22, the second gas inside the closed flow path C leaks to the main exhaust line 22 through the three-way valve 23, and therefore the second gas can more effectively suppress leakage of the exhaust gas to the bypass line 30.

Also, the gas introduction pipe 34 has the second gate valve 37, and after the second gas is introduced from the gas introduction pipe 34, the pressure in the closed flow path C can be maintained by closing the second gate valve 37 and internal leakage in the three-way valve 23 can be detected based on the change in pressure in the closed flow path C detected by the pressure gauge 35. Since the gas treatment system 10 can maintain the pressure in the closed flow path C by closing the second gate valve 37, it is easier to detect the change in pressure in the closed flow path C caused by the internal leakage, and thus internal leakage in the three-way valve 23 can be detected accurately.

Also, the gate valve 33 is a normally-open valve. As a result, if a defect occurs in the structure that operates the gate valve 33, the gate valve 33 automatically opens, and the gas flowing through the bypass line 30 is urgently released to equipment other than the gas treatment apparatus (emergency detoxification apparatus 50 in this embodiment). For this reason, the gas treatment system 10 can ensure high safety.

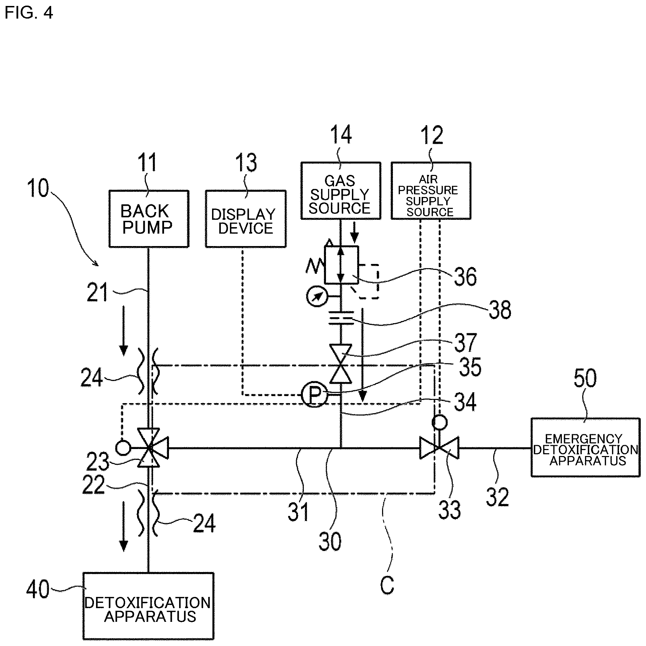

Note that the present invention is not limited to the above-described embodiment, and various modifications and combinations can be made by those skilled in the art within the technical idea of the present invention. For example, as in the modified example shown in FIG. 4, in the gas treatment system 10, a diaphragm mechanism 38 for adjusting the flow rate of the second gas may be arranged between the pressure regulator 36 and the second gate valve 37 of the bypass line 30. The diaphragm mechanism 38 is an orifice plate. The orifice plate has, for example, a through hole with an inner diameter of about 1/4 inch, but the inner diameter of the through hole is not particularly limited. Also, the configuration of the diaphragm mechanism 38 is not particularly limited as long as the flow rate of the gas passing through can be constricted, and may be, for example, a needle valve.

When using the modified example of the gas treatment system 10 described above, first, the three-way valve 23 brings the flow path of the upstream exhaust line 21 and the main exhaust line 22 into communication with each other and closes the flow path of the upstream exhaust line 21 and the bypass line 30. In synchronization with this, the gate valve 33 is closed. Next, the second gate valve 37 is opened, and the second gas is supplied from the gas supply source 14 to the closed flow path C of the bypass line 30 through the pressure regulator 36 and the diaphragm mechanism 38. The pressure P in the closed flow path C of the bypass line 30 is set to a predetermined pressure P0 (P=P0). Thereafter, the second gas is continuously supplied with the second gate valve 37 kept open. As a result, the pressure P in the closed flow path C is prevented from gradually decreasing with time, and the pressure P is maintained at the desired predetermined pressure P0. Thereafter, the exhaust gas from the back pump 11 is fed to the detoxification apparatus 40 through the upstream exhaust line 21 and the main exhaust line 22. The exhaust gas that has reached the detoxification apparatus 40 is released to the outside after the detoxification gas is subjected to detoxification treatment. The pressure P in the closed flow path C is higher than the pressure of the exhaust gas flowing through the upstream exhaust line 21 and the main exhaust line 22. Accordingly, if internal leakage occurs in the seal of the three-way valve 23, the second gas inside the closed flow path C leaks to the main exhaust line 22 through the three-way valve 23. When the second gas inside the closed flow path C leaks from the three-way valve 23 to the main exhaust line 22, the pressure P in the closed flow path C becomes lower than the initially-set predetermined pressure P0 (P<P0). The worker can determine whether or not there is leakage in the three-way valve 23 by monitoring the pressure P in the closed flow path C with the display device 13 and comparing the pressure P with the threshold value.

As described above, in the modified example of the gas treatment system 10, the second gas is continuously introduced from the gas introduction pipe 34 in a state where internal leakage in the three-way valve 23 can be detected. As a result, the gas treatment system 10 can prevent the pressure P in the closed flow path C from decreasing over time, and therefore it is possible to suitably maintain a state in which change in the pressure P in the closed flow path C can be detected even if time elapses.

Also, the gas introduction pipe 34 has a diaphragm mechanism 38 for adjusting the flow rate of the second gas. As a result, in the gas treatment system 10, the flow rate of the second gas is limited to a small amount by the diaphragm mechanism 38. For this reason, the change over time in the pressure in the closed flow path C caused by the inflow of the second gas becomes gradual. For this reason, the change in pressure in the closed flow path C caused by internal leakage in the three-way valve 23 is less likely to be buried in the change in pressure in the closed flow path C caused by the inflow of the second gas, and thus the change in pressure is easier to identify. For this reason, the gas treatment system 10 can detect internal leakage in the three-way valve 23 with high accuracy.

Also, in each of the above-described embodiments, a worker determines whether or not there is leakage in the three-way valve 23, but the determination may also be performed by a control unit such as a computer having a calculation function. The control unit can determine whether or not there is internal leakage in the three-way valve 23 by receiving the pressure detection result from the pressure gauge 35 and comparing the pressure P in the closed flow path C with the pre-set threshold value.

Also, in the modified example of the gas treatment system 10 described above, the second gas is continuously introduced from the gas introduction pipe 34 in a state where internal leakage in the three-way valve 23 can be detected, but in another modified example, the second gas may be introduced from the gas introduction pipe 34 only for a predetermined time. In order to detect the change in the pressure P in the closed flow path C caused by the internal leak in the three-way valve 23, it is necessary to keep the pressure P in the closed flow path C constant, but it is difficult to keep the pressure P constant. Furthermore, the pressure P in the closed flow path C being low makes it more difficult to keep the pressure P constant. In contrast to this, in another modification, in order to make it possible to detect internal leakage in the three-way valve 23, the gas treatment system 10 periodically (e.g., multiple times a day) opens a second gate valve 37 such that the pressure P in the closed flow path C reaches the predetermined pressure P0, and introduces second gas for inspection from the gas supply source 14 to the closed flow path C via the pressure regulator 36 and the gas introduction pipe 34. That is, the gas treatment system 10 does not need to continuously maintain the pressure P in the closed flow path C, but maintains the pressure P in the closed flow path C at a predetermined pressure P0 only for a limited short time of performing the inspection. It is easy to maintain the pressure P in the closed flow path C at a predetermined pressure P0 for a short time during which inspection is performed. For this reason, the gas treatment system 10 more easily detects change in the pressure P in the closed flow path C caused by internal leakage, and can detect internal leakage in the three-way valve 23 with high accuracy. Accordingly, the worker can determine, with high accuracy, whether or not there is leakage in the three-way valve 23 by monitoring the pressure P in the closed flow path C with the display device 13 and comparing the pressure P with the threshold value. Note that at least one of the periodic opening and closing of the second gate valve 37, control of adjustment by the pressure regulator 36, and determination of whether or not there is internal leakage in the three-way valve 23 may also be performed automatically by a control unit of a computer or the like having a calculation function.

### REFERENCE SIGNS LIST

- 10: Gas treatment system
- 21: Upstream exhaust line
- 22: Main exhaust line
- 23: Three-way valve
- 30: Bypass line
- 31: First bypass line
- 32: Second bypass line
- 33: Gate valve
- 34: Gas introduction pipe
- 35: Pressure gauge
- 36: Pressure regulator
- 37: Second gate valve
- 38: Diaphragm mechanism
- 40: Detoxification apparatus (gas treatment apparatus)
- 50: Emergency detoxification apparatus (emergency gas treatment apparatus)
- C: Closed flow path

## Claims

1. A gas treatment system comprising:
a main exhaust line for guiding exhaust gas to a gas treatment apparatus;
a bypass line for guiding the exhaust gas to equipment other than the gas treatment apparatus;
an upstream exhaust line for guiding the exhaust gas to the main exhaust line and the bypass line; and
a three-way valve capable of switching a flow of the exhaust gas from the upstream exhaust line to the main exhaust line or the bypass line,
wherein the bypass line includes:
a gate valve;
a gas introduction pipe through which a second gas is introduced between the three-way valve and the gate valve; and
a pressure gauge configured to detect pressure between the three-way valve and the gate valve, and
if the three-way valve discharges gas to the main exhaust line, the gate valve is closed to form a closed flow path between the gate valve and the three-way valve, and in a state where the second gas has been introduced into the closed flow path from the gas introduction pipe, internal leakage in the three-way valve is detectable using change in pressure detected by the pressure gauge.

2. The gas treatment system according to claim 1,
wherein the gas introduction pipe includes a second gate valve, and
after the second gas is introduced from the gas introduction pipe, the pressure in the closed flow path is maintainable by closing the second gate valve, and internal leakage in the three-way valve is detectable using the change in the pressure in the closed flow path detected by the pressure gauge.

3. The gas treatment system according to claim 1, wherein the second gas is continuously introduced from the gas introduction pipe in a state where internal leakage in the three-way valve is detectable.

4. The gas treatment system according to claim 1, wherein the second gas is introduced from the gas introduction pipe only for a predetermined time to achieve a state where internal leakage in the three-way valve is detectable.

5. The gas treatment system according to any one of claims 1 to 4, wherein the gas introduction pipe has a diaphragm mechanism for adjusting a flow rate of the second gas.

6. The gas treatment system according to any one of claims 1 to 5, wherein the gate valve is a normally-open valve.
